# EUROPEAN PATENT APPLICATION

(11) **EP 4 024 485 A1**
(43) Date of publication of application: **06.07.2022**
(21) Application number: 21020004.4
(22) Date of filing: 04.01.2021
(51) Int. Cl.: H01L 51/42

(54) **ULTRA-THIN PLASMONIC PHOTOVOLTAIC EMPLOYING AN INSULATING LAYER**

(71) Applicant: Peafowl Solar Power AB, 756 43 Uppsala (SE)
(72) Inventor: The designation of the inventor has not yet been filed

(57) **Abstract**

There is provided a charge generating assembly for a photovoltaic cell with increased overall efficiency, comprising a layer of an n-type semiconductor as an electron transporting layer 1 (ETL), a layer of metal plasmonic nanoparticles 2, an insulating layer 4 between the n-type semiconductor and the layer of metal plasmonic nanoparticles and a layer of a p-type semiconductor as a hole transporting layer 3 (HTL) .

## Description

The present disclosure relates to a charge generating assembly and its use in the field of photovoltaics and methods for its manufacture.

A photovoltaic system is a system using the process of light conversion into electricity. The light may come from the sun or any artificial source. A known example of a photovoltaic cell is a solar cell, wherein solar light is converted into electricity, which has had an increased interest in the last years.

Thin-film photovoltaics (e.g. solar cells) usually have a thickness in the range of 1 - 2 µm, and are deposited on substrates such as glass, plastic or stainless steel. They provide cost-effective and efficient solutions as a feasible alternative to other energy sources, being set to meet particularly challenging demands such as portable and lightweight consumer applications, self-charging devices, tandem cells, etc.

In a photovoltaic using plasmonic metal nanoparticles, the absorption of light by plasmonic metal nanoparticles heats the loosely bonded valence electrons in the metal nanoparticles, creating an electron hot gas. The dephasing and decoherence of the electron hot gas via the Landau damping mechanism leads to the creation of electrical hot carriers (hot electrons and holes). Conceptually, plasmonic nanostructures can be used directly in solar cells but the photo-generated electron-hole pairs are short-lived (a few fs). This makes it problematic to draw current from the device. Thus, to increase charge separation lifetime, the charge carriers can be confined to spatially separated sites where reactions will take place, e.g., by transferring them to a semiconductor (analogous to dye-sensitized solar cells). LSP hot electrons have sufficient energy to be injected into the conduction band of an electron transporting layer (e.g. TiO₂), which extends their lifetime from few fs to 100s of ns.

To make a photovoltaic (solar cell) device, the hot electrons are transferred to an electron transporting layer (ETL) material and the hot holes are transferred to a hole transporting layer (HTL). The electrical charges are subsequently extracted by conductive electrodes.

### <Summary>

It is one aim of the present disclosure to provide an ultra-thin wafer type plasmonic solar cell, that has improved efficiency, is easy to assemble, stable, environmentally compatible and which preferably also is highly transparent and colourless.

Such solar cells are suitable for self-charging technologies, colourless building integration, wearable electronics, for powering sensors and electronic gadgets in homes, and also in high-efficiency tandem solar cells and photon-energy upconversion, to mention a few non-limiting examples.

Thus, according to a first aspect, the invention relates to a charge generating assembly comprising:
- a layer of an n-type semiconductor as an electron transporting layer (ETL);
- a layer of metal plasmonic nanoparticles; and
- a layer of a p-type semiconductor as a hole transporting layer (HTL); further comprising
an insulating layer between the electron transporting layer and the layer of metal nanoparticles.
To ensure low interference and preferably also high transparency with metal particles individual plasmonic process, the metal nanoparticles layer is not compact, meaning the nanoparticles are purposely deposited sparsely from each other as sub monolayers. This configuration makes it possible for contact between ETL and HTL parts of the cell, leading to a high amount of recombination events that decrease the overall photovoltaic device efficiency. Recombination events at their interface, also known as an interfacial shunt, relates to the process where hot electrons and holes recombine and release energy, effectively reducing electrical charge carriers' collection at the electrodes.

By adding an insulating layer between the ETL and metal nanoparticles, the interaction between the ETL and HTL layers is suppressed, which avoids recombination events at their interface.

Furthermore, by adding an insulating layer between the ETL and metal nanoparticles prevents electronic levels pinning, improving photovoltaic (solar cell) open-circuit voltage. The pinning of electronic levels relates to the equilibration of the Fermi level of the metal nanoparticle and n-type semiconductor (ETL) that occurs when the two interfaces come into contact. The insulating layer creates a physical barrier, preventing that from happening.

### <Definitions>

The term "transparent" is used here in its broadest sense, meaning the quality an object or substance has when you can see through it, or when it does not significantly influence the perception of the underlying material. Different degrees of transparency are required depending on the intended use of the solar cells disclosed herein. For example, a high degree of transparency is desired when the solar cells are incorporated on window glass, and a lower degree of transparency when incorporated on other building materials.

The term "colourless" as used here, in relation to a layer, system or device, refers to a colour-neutral layer or device that does not have a distinguishable colour, as measured using using the CIE 1931 RGB colour space developed by the International Commission on Illumination (CIE) in 1931.

The term "self-assembly" refers to the spontaneous assembly of precursor molecules to form nanostructured objects, and includes the option of asserting entropic control and/or chemical control over the self-assembly process in order to optimize the properties of the resulting material.

### <Electron Transporting Layer>

The term "n-type semiconductors" which is used with the same meaning as "electron transporting layer (ETL)" refers to semiconductor materials in which electrons are the majority carriers and holes are the minority carriers.

Examples of suitable ETL materials include TiO₂, ZnO, SnO₂, SrTiO₃, BrTiO₃, Sb₂O₅, doped ZnO (eg AI:ZnO, In:ZnO), doped Sb₂O₅ (eg. Sn-Sb₂O₅) and combinations thereof. Preferably, the ETL materials are TiO₂ and SnO₂.

According to a preferred embodiment, the ETL layer has a thickness of about 200 nm or less, preferably 150 nm or less, more preferably 120 nm or less, e.g. 100 nm, 80 nm, 70 nm or less. More preferably, the ETL layer is transparent. Even more preferably, the ETL layer is transparent and colourless.

The thickness of the ETL layer is represented by the average thickness as determined for example by Scanning Electron Microscopy (SEM).

### <Metal nanoparticles>

Any metal nanoparticle may be used in the layer of metal nanoparticles, as long as it provides optical absorption in the optical range defined as electromagnetic spectrum ranging from UV to near Infrared (300-1200 nm), measured by UV-Vis optical absorption and reflectance.

Furthermore, preferably the particles have less than 200 nm in size irrespective of their geometrical shape, in order to further decrease light scattering and reflection. Particle size according to the present invention is assessed by Dynamic Light Scattering (DLS).

The metal nanoparticles are preferably chosen from copper, gold, silver or aluminium nanoparticles. More preferred, the metal nanoparticles are silver nanoparticles.

The layer of nanoparticles is formed as a sub-monolayer wherein the nanoparticles are situated sparsely from each other, preferably at a distance of at least 3 nm from each other, in order to have low interference in the plasmonic effect of each individual nanoparticle.

Preferably, the concentration of nanoparticles in a sub-monolayer is between 10-20% of a compact monolayer, to obtain a photovoltaic system which is colourless or with high transparency.

In one embodiment, the layer of nanoparticles has a thickness in the range of about 15 to about 250 nm, as measurable by SEM. This has the advantage of the layer absorbing incoming light of the entire solar spectrum.

The thickness of the layer made of metal nanoparticles may be determined by SEM.

According to preferred embodiment, freely combinable with any of the above embodiments, the metal nanoparticles are synthesized by using a reducing and a stabilizing agent. Examples of reducing agents include NaBH₄, N₂H₄, ascorbic acid, betanin, polyols for example ethylene glycol, di-ethylene glycol, triethylene glycol, tetraethylene glycol, polyethylene glycol. Examples of stabilizing or growth-limiting agents include betanin, polyvinylpyrrolidone, polyvinyl acetate, polyols such as for example ethylene glycol, di-ethylene glycol, triethylene glycol, tetraethylene glycol polyethylene glycol or ascorbic acid. In a preferred embodiment, ascorbic acid is used as the stabilizing agent

### <Hole Transporting Layer>

The term "p-type semiconductors" which is used herein having the same meaning with "hole transporting layer (HTL)" refers to semiconductor materials in which holes are the majority carriers, or positively charged carriers, and electrons are the minority carriers.

Examples of suitable HTL materials include NiO, CuXO₂ (wherein X is for example Cr, B, Al, Ga, In, Sc, Fe), PEDOT.PSS (poly(3,4-ethylenedioxythiophene) polystyrene sulfonate), Spiro:OMeTAD (2,2',7,7'-Tetrakis[N,N-di(4-methoxyphenyl)amino]-9,9'-spirobifluorene), PTAA (Poly[bis(4-phenyl)(2,4,6-trimethylphenyl)amine), and combinations thereof. Preferably, the HTL materials are Spiro:OMeTAD, PEDOT:PSS and PTAA.

According to a preferred embodiment, the HTL layer has an average thickness of about 700 nm or less, preferably 400 nm or less, more preferably 150 nm or less, e.g. 120 nm, 100 nm, 50 nm or less. More preferably, the HTL layer is transparent. Even more preferably, the HTL layer is transparent and colourless.

The thickness of the HTL layer may be determined by SEM.

### <Insulating layer>

In a preferred embodiment, the insulating layer is composed of materials with a large energy difference between valence and conduction band, i.e., large band gap, and no or very low electrical conductivity. The conduction band edge should be at 3.5 eV or less from the vacuum and the valence band should be 6.5 eV or more from the vacuum.

As an example, the insulating layer can be made of SiO2, Al2O3, ZrO2, tetraethyl orthosilicate (TEOS), (3-aminopropyl)triethoxysilane (APTES), (3-mercaptopropyl) triethoxysilane, aminophenyltrimetoxysilane, organophosphates (CₙH₂ₙ₊₁-PO(OH)₂), amino-organophosphates (H₂N-CₙH₂ₙ-PO(OH)₂), thiol-organophosphates (HS-C₂H₂ₙ-PO(OH)₂), organocarboxilates (CₙH₂ₙ₊₁-CO(OH)), amino-organocarboxilates (H₂N-CnH₂ₙ₊₁-CO(OH)) and thiol-organocarboxilates (HS-CₙH₂ₙ₊₁-CO(OH)),

In a preferred embodiment, the insulating layer is made of a material that contains functional groups that selectively bond to the metal nanoparticles (e.g. -NH₂ (primary amines), -NRH (secondary amines), -SH, -SCN, -CN, nitriles, -OH, alkene, alkyne, etc). Examples of such compounds are (3-aminopropyl)triethoxysilane, (3-mercaptopropyl)triethoxysilane, triethoxy(3-thiocyanatopropyl)silane; 3-cyanopropyltriethoxysilane, 4-(trimethoxysilyl)-butyronitrile, 3-(trimethoxysilyl)propyl methacrylate, 3-(trimethoxysilyl)propyl acrylate, organophosphates (CₙH₂ₙ₊₁-PO(OH)₂), amino-organophosphates (H₂N-CₙH₂ₙ-PO(OH)₂), thiol-organophosphates (HS-C₂H₂ₙ-PO(OH)₂), organocarboxilates (CₙH₂ₙ₊₁-CO(OH)), amino-organocarboxilates (H₂N-CₙH₂ₙ₊₁-CO(OH)) and thiol-organocarboxilates (HS-CₙH₂ₙ₊₁-CO(OH)). When these materials are used, the metal nanoparticles may adhere and stick to the surface of the insulating layer. This prevents particles movement and avoids the formation of particle clustering and/or sintering, which would lead to loss of the plasmonic properties. Additionally, the distance between the metal nanoparticles and the distance between the metal nanoparticles and the ETL layer may be controlled, based on the number of nanoparticles used and deposition technique .

Preferably, the insulating layer has a thickness of 10 nm or less, more preferably 1 nm or less, even more preferably 1nm or less. When the thickness of the insulating layer is 10nm or less, it is ensured that hot electrons are effectively transferred from the metal nanoparticles layer to the ETL. If the thickness of the insulating layer is less than 0.5nm, then the insulating effect may not be achieved.

### <Other embodiments>

According to another embodiment, the p-type semiconductor, the metal nanoparticles and/or the insulating layer are covalently linked by means of a molecular linker. The requirements for the molecular linker are that it should provide an excellent electronic coupling because of its good π-conjugated properties, rigidity and planarity. Preferably, molecules with selective reactive groups to each component, namely carboxylic or phosphonic acid (coordination to p-type semiconductor) and amine or thiols (coordination to the nanoparticles) are used. Examples of suitable molecular linkers are as disclosed in the international application WO2018/178153 A1, and are incorporated herein by reference.

### <Photovoltaic Cell>

In a further aspect, the present invention relates to a photovoltaic device comprising a charge generating assembly as described above wherein the electron transporting layer, the layer of metal nanoparticles and the hole transporting layer are sandwiched between two conductive substrates.

The two conductive substrates may be the same or different and may be made, for example, of a transparent glass material with a conductive layer on one of the sides or of a conductive polymer. Preferred examples of transparent glass material are indium tin oxide (ITO), fluorinated tin oxide (FTO), aluminium doped zinc oxide (AZO) or indium doped zinc oxide (IZO). Similarly, preferred examples of a conductive polymer substrate may be either a polymer substrate with a conductive layer on one side or a substrate made of a conductive polymeric material intrinsically conducting polymer or, for example, a substrate made of a conductive thermoplastic composite material.

One example of the architecture of a photovoltaic device according to the present invention comprises a "bottom" layer being made of a conductive material, for example a gold layer and a "top" layer acting as the counter electrode to the bottom layer, which in the case of a transparent solar cell is also a conductive transparent substrate, for example an FTO glass. The charge generating assembly is sandwiched between the two conductive layers such that the HTL layer is in contact with the bottom layer made of gold and the ETL layer is in contact with the transparent top layer. In such an architecture, the bottom layer acts as an anode and the top layer as a cathode layer.

Alternatively, the architecture corresponds to an inverted cell wherein the HTL layer is in contact with a "top" transparent conductive layer while the ETL layer will contact the "bottom" conductive layer.

By a "top" layer according to the present invention, it is meant a layer that will first contact the source of light, e.g. solar light.

In a preferred embodiment, the photovoltaic device is a solar cell.

By using an architecture as described above, photovoltaic devices (e.g. solar cells) with a thickness of less than 400 nm can be achieved, which can be implemented as transparent, semi-transparent or colourless surfaces and incorporated in other building elements without adding bulk or significantly changing their appearance.

### <Method of producing a charge generating assembly>

In another aspect, the invention relates to a method of producing a charge generating assembly comprising the steps of:
a) depositing an insulating layer on an electron transporting layer (ETL)
b) loading, on the insulating layer, metal nanoparticles to form the layer of metal plasmonic nanoparticles; and
c) coating the layer of metal plasmonic nanoparticles with a hole transporting layer (HTL)

According to a preferred embodiment, the insulating layer is deposited by immersing the ETL layer in a solution out of which the insulating layer is formed.

Yet according to a preferred embodiment, the metal nanoparticles are loaded onto the insulating layer by inkjet printing, screen-printing, drop-casting, spin-coating, dipcoating, spray-coating, atomic layer deposition, sputtering, evaporation or any other way that allows the formation of a sub-monolayer on the insulating layer. More preferred, inkjet printing is used.

Yet according to a preferred embodiment, the HTL are loaded onto of the metal nanoparticles layer by inkjet printing, screen-printing, drop-casting, spin-coating, dipcoating, spray-coating, atomic layer deposition, sputtering, evaporation or any other way that allows the formation of continuous HTL layer. Still according to a preferred embodiment, the HTL layer was deposited by spin-coating.

All the above presented methods are well known to the skilled person in the art and can be performed without undue burden.

### <Method of producing a photovoltaic cell>

In a further aspect, the invention provides a method for producing a photovoltaic device, more specifically a solar cell by using the charge generating assembly as described above wherein:
a1) a conductive substate is coated with the electron transporting layer before step a) described above; and
d) a further conductive substrate is coated on top of the hole transporting layer after step c) described above

In a preferred embodiment, step a1) is performed by spray pyrolysis. In a yet preferred embodiment, step d) is performed by evaporation of the conductive substrate (back contact) on the rest of the assembly.

### <Use of cell>

In a further aspect, the invention relates to building elements comprising a charge generating assembly or a photovoltaic device, in particular a solar cell according to any one of the embodiments described above, or a device produced according to any of the methods described above.

According to a preferred embodiment, said building element is chosen from a window, a roof element, a wall element, or other structural or functional element.

In yet a further aspect, the invention relates to consumer electronics comprising a charge generating assembly or a photovoltaic device, in particular a solar cell according to any one of the embodiments described above, or a device produced according to any of the methods described above.

According to a preferred embodiment, said consumer electronics relate to any equipment intended for everyday use and that preferably requires a low electricity consumption, such as mobile phones, tablets, watches, smart devices, sensors, video cameras, etc.

Different aspects and embodiments of the invention will be described in closer detail below, in the description and examples, with reference to the drawings in which:
Fig. 1a schematically shows a conceptual design of a plasmonic solar cell without an insulating layer, used as a comparative example
Fig. 1b schematically shows a conceptual design of a plasmonic solar cell with an insulating layer, according to a preferred embodiment of the present invention
Fig. 2 shows the light absorption spectrum of silver nanoparticles used in a plasmonic solar cell according to a preferred embodiment of the present invention
Fig. 3 shows the I-V curve for solar cell with insulating layer according to a preferred embodiment of the present invention
Fig. 4 shows the I-V curve for solar cell without an insulating layer

### <Examples>

### Example 1 synthesis of metal nanoparticles

Silver metal nanoparticles were synthesized starting from the respective metal precursor, for example AgNO₃, a reducing agent, and a stabilizing agent. Examples of reducing agents and stabilizing agents were mentioned earlier in the present invention. All reagents were purchased from Sigma-Aldrich / Merck and were of analytical quality.

The present inventors followed the protocol presented in Dong et al., 2015, incorporated herein by reference, changing selected parameters such as the concentration of components, solvents, reaction temperature, and reaction time in order to optimize the geometry of the nanoparticles and the size distribution.

Two bottom-up synthesis procedures were adopted to prepare Ag nanoparticles (NPs) stabilized with betanin and derivatives (Bts-Ag NPs). The Bts-Ag NPs are synthesized in an automated microfluidic reactor (Asia Syringe Pump, Syrris Ltd., Royston, UK) via alkaline hydrolysis of natural betanin. Optimization via a multi-objective genetic algorithm ensures that Ag NPs are homogeneous in size and narrow light absorption. For example Fernandes *et al.* obtained particles with sizes between 40-45 nm determined by dynamic light scattering (DLS, NanoS, Malvern Panalytical Ltd., Malvern, UK) and atomic force microscopy (AFM, Nanosurf AG, Liestal, Switzerland) and central absorption at 405 nm (DH-2000-BAL connected to a USB-4000 spectrometer, Ocean Optics Inc., Largo, FL, USA).

As an alternative, Bts-Ag NPs are synthesized in a microwave synthesis reactor (Monowave 50, Anton Paar GmbH, Austria) via acid or alkaline hydrolysis of natural betanin extracted from beetroot. This procedure is very fast and produces Bts-Ag NPs in high yields with high degree of reproducibility. The nanoparticles are polydispersed ensuring a better matching with solar spectrum. The method results in particles with sizes between 20-200 nm as determined by dynamic light scattering (DLS, NanoS, Malvern Panalytical Ltd., Malvern, UK) and atomic force microscopy (AFM, Nanosurf AG, Liestal, Switzerland) and light absorption spanning from 350-720 nm (DH-2000-BAL connected to a USB-4000 spectrometer, Ocean Optics Inc., Largo, FL, USA).

If a linker is used, the pH of the Ag nanoparticle suspension is adjusted to 4 - 5 and the particles are coated with pABA (Sigma-Aldrich), which anchors to Ag surface via the -NH₂.

In the same way, gold, copper and aluminium nanoparticles may be obtained starting from the respective metal precursor, as it is obvious for a person skilled in the art, for example CuSO₄ or CuCl₂ for copper nanoparticles or HAuCl₄ for gold nanoparticles.

The resulting silver, gold and copper nanoparticles are tested in the set-up disclosed

### Example 2 semiconductor nanoparticles

Anatase, a nanopowder of TiO₂ with a particle size of 3 nm and 20 nm was obtained from Sachtleben Chemie GmbH, Duisburg, Germany.

Anatase, a nanodispersion of TiO2 with a particle size of 20 nm was obtained from. NYACOL Nano Technologies, Inc., Ashland, USA

Alternatively, anatase is produced by spray pyrolysis of Ti(IV) diisoproxoide bis(acetylacetonate) and 0.4 ml acetylacetone in 9 ml of ethanol from Sigma-Aldrich.

Spriro:OMeTAD used as a HTL layer was obtained from Ossila Ltd, Sheffield, UK.

### Example 3 insulating layer

ZrO2 layer was obtained from a solution of ZrOCl2 octahydrate in DI-water purchased from Sigma-Aldrich.

### Example 4 Photovoltaic solar cell

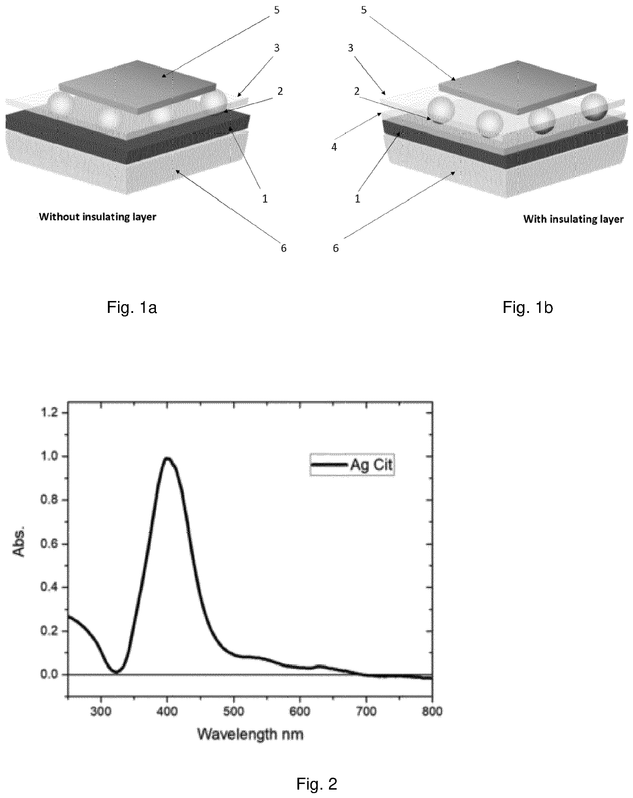

Figure 1 shows a typical solar cell construct without (Fig. 1a) and with (Fig. 1b) an insulating layer, which in this case is ZrO2. The insulating layer 4 is positioned between an electron transporting layer 1 (TiO2) and a sub-monolayer of silver nanoparticles 2.

On the other side of the silver nanoparticles is found a hole transporting layer 3 (HTL) made of Spiro:OMeTAD.

The above-mentioned structure is sandwiched between two conductive substrates, that is a gold back contact 5 on top of the HTL layer and a FTO glass 6 on the opposite side, in contact with the TiO₂ layer 1.

Scanning electron microscopy (SEM) imaging (Figure 2-3) was performed to assess layers thickness. The HTL layer 3 had a thickness of approximatively 518,5 nm and the ETL layer 1 had a thickness of approximatively 164,6 nm. As the ZrO2 layer 4 has less than 1 nm, it could not be imaged by SEM because of resolution limits, however its presence can be acknowledged by X-ray photoelectron spectroscopy (XPS) and increase in solar cell performance.

The solar cells contained silver nanoparticles as light absorber with sizes in the 20-35 nm range, equating to light absorption in between 400-500 nm, as can be seen from the light absorption spectrum of Figure 2.

A solar cell according to this embodiment was obtained in the following way:
a1) An FTO glass was cut into sizes of 14 mm x 24 mm. These dimensions are chosen to give some tolerance of the glass pieces for the final deposition steps and measurement. After cutting, the glass was patterned by chemical etching. The long sides of each pre-cut substrate are taped (use 3M-Magic tape or Kapton) so that they cover around 2 mm on each end. The FTO is then covered with Zinc powder (only a pinch required). This is followed by adding drops of 2M HCI onto the FTO glass to start the etching reaction. After approximatively 2 min the etching is complete and the etching solution is washed off with water. The glass pieces are further washed by sonication in 2% Hellmanex solution (diluted with DI water) for 30 min. Afterwards, washing by sonication in DI water for 15 minutes, followed by 15 minutes of IPA is performed. The cleaning procedure is finished with a 15 min UV-Ozone treatement process.

Subsequently, a solution of 0.6 ml Ti(IV) diisoproxoide bis(acetylacetonate) and 0.4 ml acetylacetone in 9 ml of Ethanol is prepared for the spray pyrolysis process. The pre-cut, washed and etched substrate is loaded on the spray pyrolysis hotplate and is covered approximatively 3 mm with another glass-piece. The hotplate is set to 500°C and then held for 30 min at this temperature before starting the deposition. After this step, spraying is performed until one complete cycle is finished. At least 5 cycles are required to be sprayed (approximatively 18ml of solution). After finishing the spraying, the substrate is left for another 30 min at 500°C for annealing and then it is left to cool down. In this way, an TiO₂ ETL layer deposited on an FTO glass is obtained.
a) A ZrO₂ insulating layer is deposited on the ETL layer (TiO₂) as follows: the assembly from the previous step was cleaned in UV-Ozone for 20 min. Subsequently, the assembly comprising the TiO₂ film was immersed for 10 mins in a solution of 20 mM ZrOCl2 octahydrate in DI-water (1.289 g in 200 mL), then the film was rinsed with Dl-water, dried gently using air-gun and finally annealed in a hotplate in air at 180°C for 1 hour.
b) The layer of metal nanoparticles is then loaded on the insulating layer. More specifically, Ag NPs were synthesized from 0.8 ml Glycerol, 8.2 H₂O, 0.1 ml AgNO3, and 0.5 ml Na-citrate, which were mixed in a microwave tube. After 30 min at 95°C, a solution of Ag NPs was obtained and then purified in centrifuge at 14.8 K rpm for 20 min. The NPs were then re-dispersed in 2 ml H₂O.
   Further, 0.05 ml HNO₃ (0.1 M) was mixed with 1 ml Ag NPs and around 0.1 ml of the mixture was drop casting on the isolating film for 20-30 min. Using DI-H2O, the FTOATiO2/ZrO2/Ag NPs films were washed probably and dried using Ar gas.
c) Spiro-OMeTAD was used as hole transporting material. 0.04-0.05 ml of Spiro solution (180 mg of Spiro-OMeTAD, 1 ml of Chlorobenzene, 16.5 µl of t-Butyl pyridene, and 11.3 µl of Li-TFSI) was use for spin-coating at 3000 rpm for 30 sec. The films were left overnight to oxidize the Spiro layer in dark.
d) Finally, 80 nm of gold was evaporated onto the HTL layer as a back contact for the solar cell. The evaporation process was performed using a Leica instrument.

By following this procedure, a solar cell as presented in Fig. 1b was obtained.

In a similar way, a solar cell for a comparative example as presented in Fig. 1a was obtained, wherein the insulating layer was not deposited and the metal nanoparticles were loaded directly on the TiO₂ layer.

### Example 5 Assessing the efficiency of the photovoltaic solar cell comprising an insulating layer according to the invention

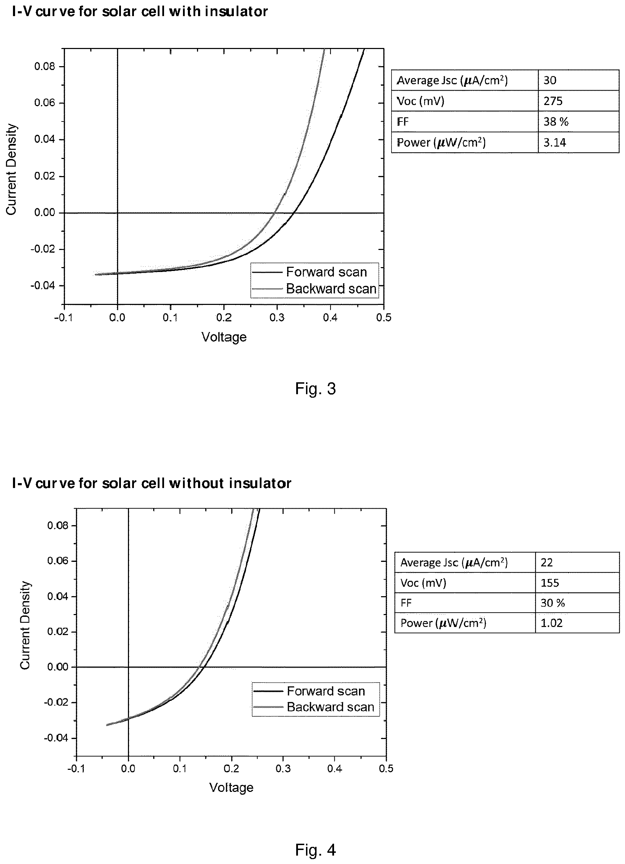

The solar cells of Figs. 1a and 1b were tested in a solar simulator using standard 1 SUN illumination (at AM 1.5 G condition, 1 sun is defined as equal to 100 mW/cm2) in a presence of a UV filter in order to remove wavelengths below 400 nm. The I-V curves (current density vs voltage) of the solar cells with insulating layer according to the present invention and without an insulating layer used as a comparative example are shown in figures 3 and 4, respectively. The average performance is also reported, namely photocurrent (Jsc), open-circuit voltage (Voc) and fill factor (FF).

From Figs. 3 and 4 it can be seen that the presence of the insulating layer increases the overall efficiency of the cell, due to the improvement in all the solar cell parameters (photocurrent (Jsc), open-circuit voltage (Voc) and fill factor (FF)). Control over the insulating layer is essential to decrease deviation between forward and backward IV-scans, i.e., solar cell hysteresis.

## Claims

1. A charge generating assembly for a photovoltaic cell comprising:
- a layer of an n-type semiconductor as an electron transporting layer (ETL);
- a layer of metal plasmonic nanoparticles ; and
- a layer of a p-type semiconductor as a hole transporting layer (HTL); and
**further comprising:**
an insulating layer between the n-type semiconductor and the layer of metal plasmonic nanoparticles.

2. The charge generating assembly according to claim 1 wherein the metal plasmonic nanoparticles are selected from the group consisting of copper, gold, silver or aluminum.

3. The charge generating assembly according to claims 1 or 2 wherein the layer of metal plasmonic nanoparticles is a sub-monolayer.

4. The charge generating assembly according to claim 3, wherein the metal plasmonic nanoparticles are situated at a distance of at least 3 nm from each other.

5. The charge generating assembly according to claims 3 or 4, wherein the metal plasmonic nanoparticles have a concentration between 10-20% of a compact monolayer.

6. The charge generating assembly according to any preceding claim, wherein the insulating layer is made of a material that contains functional groups that selectively bond to the metal nanoparticles.

7. The charge generating assembly according to any preceding claim, wherein the insulating layer has a thickness of 10 nm or less, more preferably 3 nm or less, even more preferably 1nm or less.

8. The charge generating assembly according to any preceding claim, wherein the electron transporting layer, the layer of metal plasmonic nanoparticles and the hole transporting layer are linked by covalent bonds by means of one or more molecular linkers.

9. Photovoltaic device comprising:
- a charge generating assembly according to any preceding claim, wherein the electron transporting layer and the hole transporting layer are sandwiched between two conductive substrates.

10. The photovoltaic device according to claim 9 that is a solar cell.

11. Method of obtaining a charge generating assembly according to any of claims 1 to 8, comprising the steps of:
a) depositing an insulating layer on an electron transporting layer (ETL)
b) loading, on the insulating layer, metal nanoparticles to form the layer of metal plasmonic nanoparticles; and
c) coating the layer of metal plasmonic nanoparticles with a hole transporting layer (HTL)

12. The method according to claim 11 for obtaining a photovoltaic device according to claims 9 or 10, further comprising the steps:
a1) coating a conductive substate with the electron transporting layer (ETL) before step a); and
d) coating a further conductive substrate on top of the hole transporting layer (HTL) after step c).

13. Building element comprising a charge generating assembly according to any of claims 1 to 8 or a photovoltaic device according to claims 9 and 10.

14. Consumer electronic device comprising a charge generating assembly according to any of claims 1 to 8 or a photovoltaic device according to claims 9 and 10.
